# EUROPEAN PATENT APPLICATION

(11) **EP 0 899 870 A1**
(43) Date of publication of application: **03.03.1999**
(21) Application number: 98402075.0
(22) Date of filing: 18.08.1998
(51) Int. Cl.: H03F 1/32

(54) **Apparatus and method for pre-distortion correction of a power amplifier**

(30) Priority: 27.08.1997 US 57096 P
(71) Applicant: HARRIS CORPORATION, Melbourne, FL 32919 (US)
(72) Inventor: Danielsons, David, Hannibal, MO 63401 (US); Merideth, Bruce, Mendon, IL 62351 (US)
(74) Representative: Kopacz, William James

(57) **Abstract**

Linear and non-linear distortion in high power amplifiers used in television and digital television transmitters and amplifiers cause unwanted inter modulation products. Spectral regrowth limits the maximum power available from the amplifying device and can render it useless. Spectral regrowth from the amplifying device is caused from deviations in the amplifiers ability to reproduce the input signal multiplied by its gain. These deviations are caused by AM to AM and AM to PM conversion within the amplifier. Linear distortions due to frequency response errors and phase response errors can exist in the amplifier. When multiple amplifiers are combined in parallel in high power systems, these linear distortions interact with the non-linear distortions and can make conventional pre-correction circuits ineffective. The invention provides a method and apparatus for compensating or pre-correcting these linear and non-linear distortions.

## Description

The present invention relates to linear and non-linear distortion in high power amplifiers, used in digital television transmitters. In high power amplifiers used in television and digital television transmitters, amplifiers cause unwanted inter modulation products causing spectral regrowth. Spectral regrowth limits the maximum power available from the amplifying device and can render it useless. Spectral regrowth from the amplifying device is caused from deviations in the amplifiers ability to reproduce the input signal multiplied by its gain. These deviations are caused by AM to AM and AM to PM conversion within the amplifier. Linear distortions due to frequency response errors and phase response errors can exist in the amplifier. When multiple amplifiers are combined in parallel in high power systems, these linear distortions interact with the non-linear distortions and can make conventional pre-correction circuits ineffective. The present invention provides apparatus for compensating or pre-correcting these linear and non-linear distortions, and associated methods.

The present invention includes a amplifier circuit having an amplifier path and including a signal source, an intermediate amplifier stage, a power amplifier stage connected sequentially, in series along said amplifier path, said power amplifier stage includes a plurality of amplifiers operationally connected in parallel, a plurality of correction means, each os said amplifiers subjection and inputted signal to shifts away from this intended values, each of said correction means being associated with one of the said plurality of amplifiers and connected between an output of said intermediate amplifier stage and said associated amplifier, and each of said correction means for pre-distorting the signal input to said associated amplifier to compensate for the distortion caused by said associated amplifier.

The invention also includes a amplifier circuit for amplifying a signal, said amplifier circuit comprising a plurality of an amplifier stages in series along an amplifier path, each of said amplifier stages having an amplifier which subjects an inputted signal to distortion shifts away from their intended values, a plurality pr pre-corrector means, each of said pre-corrector means being associated with, and in series with, one of said amplifier stages and for pre-distorting the signal input to said associated amplifier stage to compensate for the distortion shifts of the associated amplifier, in which at least one of said pre-corrector means includes for compensating for phase and amplitude distortion caused by said associated amplifier stage.

The invention furthermore includes amethod for providing a amplified, corrected signal from and amplifier circuit, the amplifier circuit having an amplifier path and including a signal source, and intermediate amplifier stage, and a power amplifier stage connected sequentially, in series along said amplifier path, the power amplifier stage includes a plurality of amplifiers operationally connected in parallel, each of said amplifiers subjecting and inputted signal to shifts away from their intended values, said method comprising providing a plurality of correction means, connecting each of the correction means to be associated with one of said plurality of amplifiers and to be connected between an output of said intermediate amplifier stage and said associated amplifier, and pre-distorting the signal from the intermediate amplifier and input to the associated amplifier at each of the correction means to compensate for the distortion caused by said associated amplifier.

The invention will now be described, by way of example, with reference to the accompanying drawings in which:

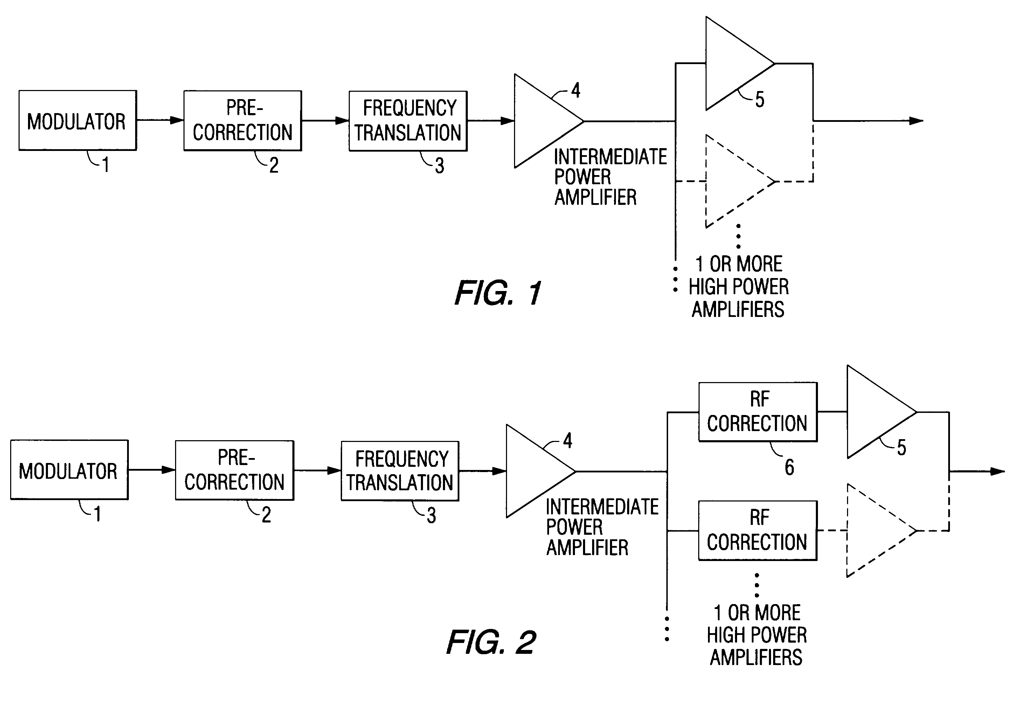

Referring to figure 1, a device consists of modulation source 1, pre-correction circuits 2, a frequency translation circuit 3, an intermediate amplifier 4 and high power amplifiers 5. Pre-correction circuits 2 consisting of AM to AM and AM to PM conversions are used to compensate for distortions in the intermediate amplifiers 4 and high power amplifiers 5. When one or more high power amplifiers 5 are combined, the combined nonlinear distortions due to each high power amplifier is an aggregate some of each individual amplifiers distortion. Pre-correction circuit 2 attempt to compensate for the combined sum. The result of this pre-correction is an overall improvement in the inter modulation and the spectral regrowth. However due to linear distortions in each high power amplifiers 5 this overall improvement in inter modulation products of the combined amplifiers can be severely limited or even worsened. This is due to the phase difference in each high power amplifier not matching each other.

Figure 2 illustrates a system performance that can be improved by the addition of a RF pre-correction circuit 6 at the input to each high power amplifier 5. Each RF pre-corrector is set to compensate each high power amplifier. This results in a system with uniformity between each high power amplifier and lower inter modulation products are obtained at the output of each high power amplifier then could be obtained with the prior art. In addition linear distortions in each high power amplifier can be compensated for and the combined high power amplifiers have a resulting lower inter modulation products.

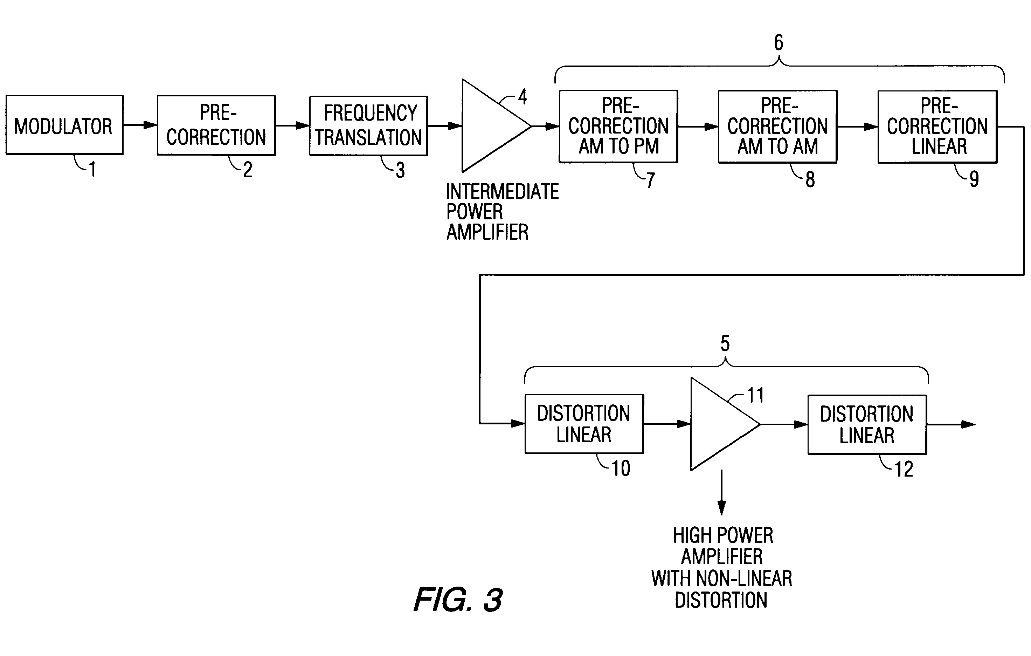

In Figure 3 the high power amplifier 5 can be expanded to show its individual distortion components. It consists of a linear distortion 10 due to input matching circuits. These consist of the matching network used in solid state devices or input cavities as found in tube type devices. These linear distortions consist of frequency response errors and phase errors from the ideal amplifier's straight line characteristics. The actual amplifying device 11 whether it be solid state or tube has nonlinear distortions due to its mode of operation i.e. class A, A/B, etc. and its saturation characteristics. Finally the amplifying device's output network 12 contains linear distortion as well.

The RF pre-correction circuits 6 are expanded to it's simplistic form. It consists of a linear pre-correction circuit 9, a non-linear AM to PM pre-correction circuit 8 and a non-linear AM to AM pre-correction circuit 7. The linear pre-correction circuit 9 has the function to precisely pre-correct the amplifying devices linear distortion 10. The non-linear pre-correction circuits 7 and 8 precisely compensated for the amplifying device 11 non-linear distortion. The significant result of this circuit order is that the cascade of circuit 7, 8, 9, 10 and 11 closely resembles and ideal amplifying device with no distortion. And when ideal amplifiers are combined in parallel they result in a combined amplifier that resembles the original ideal amplifier.

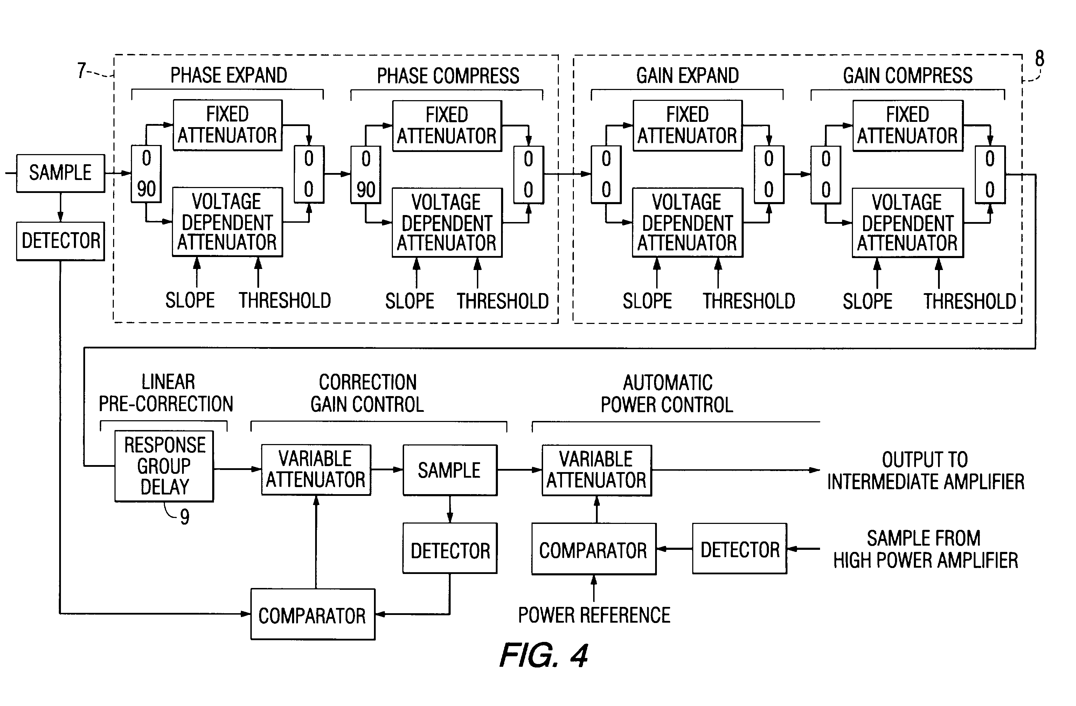

In Figure 4 pre-correction circuits for the generation of AM to PM pre-correction consists of quadrature type circuit. A phase expansion circuit is created when two rf paths are created with a 90 degree phase difference. One path is processed by a fixed rf attenuator. The second path is processed by a voltage dependant attenuator rf attenuator. This attenuator has the ability to remove attenuator only when the rf level reaches a specified voltage level as determined by the slope input. When the two paths are combined, the result is a signal that has it's phase transfer function modified from it's original input by the settings of the slope and threshold input.

A phase compression circuit is created when two rf paths are created with a 90 degree phase difference. One path is processed by a fixed attenuator. The second path is processed by a voltage dependent attenuator rf attenuator. This attenuator has the ability to apply attenuator when the rf level reaches a specified voltage level as determined by the threshold input in addition it applies a specific amount of attenuator as determined by the slope input. When the two paths are combined, the result is a signal that has it's phase transfer function modified from it's original input by the settings of the slope and threshold input.

Pre-correction circuits for the generation of AM to AM pre-correction consists of an in phase type circuit. A gain expansion circuit is created when two rf paths are created with a 0 degree phase difference. One path is processed by a fixed rf attenuator. The second path is processed by a voltage dependent attenuator rf attenuator. This attenuator has the ability to remove attenuator only when the rf level reaches a specified voltage level as determined by the threshold input in addition it removes a specific amount of attenuator as determined by the slope input. When the two paths are combined, the result is a signal that has it's amplitude transfer function modified from it's original input by the settings of the slope and threshold input.

A gain compression circuit is created when two rf paths are created with a 0 degree phase difference. One path is processed by a fixed rf attenuator. The second path is processed by a voltage dependent attenuator rf attenuator. This attenuator has the ability to apply attenuator only when the rf level reaches a specified voltage level as determined by the threshold input in addition it applies a specific amount of attenuation as determined by the slope input. When the two paths are combined, the result is a signal that has it's amplitude transfer function modified from its original input by the setting of the slope and threshold input.

In order to keep the amplitude of the rf signal constant through the correction circuits as the pre-correction circuits are adjusted, an automatic gain control circuit is used. A sample of the incoming signal is detected to create an input reference. A sample of the correction output is sampled and detected to create an output reference. The input and output references are compared and an error voltage controls a variable attenuator in such a way as to keep the overall gain through the correctors at a constant level.

As a further system enhancement an automatic power control loop is used to keep the output level of the high power amplifiers at a constant output level. A sample of the high power amplifier output is detected to form a signal which is proportional to the output power level. This signal is compared with a power reference and an error signal is created which controls an attenuator in such a way as to hold the output amplifiers at a constant level enhances the combining losses of multiple amplifiers. In one preferred embodiment, the slope and the threshold of each of the voltage dependent attenuators is set/adjusted by an operator.

Linear and non-linear distortion in high power amplifiers used in television and digital television transmitters and amplifiers cause unwanted inter modulation products. Spectral regrowth limits the maximum power available from the amplifying device and can render it useless. Spectral regrowth from the amplifying device is caused from deviations in the amplifiers ability to reproduce the input signal multiplied by its gain. These deviations are caused by AM to AM and AM to PM conversion within the amplifier. Linear distortions due to frequency response errors and phase response errors can exist in the amplifier. When multiple amplifiers are combined in parallel in high power systems, these linear distortions interact with the non-linear distortions and can make conventional pre-correction circuits ineffective. The invention provides a method and apparatus for compensating or pre-correcting these linear and non-linear distortions.

## Claims

1. An amplifier circuit having an amplifier path and including a signal source, an intermediate amplifier stage, a power amplifier stage connected sequentially, in series along said amplifier path, said power amplifier stage includes a plurality of amplifiers operationally connected in parallel, a plurality of correction means, each of said amplifiers subjecting an inputted signal to shifts away from their intended values, each of said correction means being associated with one of the said plurality of amplifiers and connected between an output of said intermediate amplifier stage and said associated amplifier, and each of said correction means for pre-distorting the signal input to said associated amplifier to compensate for the distortion caused by said associated amplifier.

2. An amplifier circuit as claimed in claim 1, wherein each of said correction means includes means for compensating for phase and amplitude distortion caused by said associated amplifier, and each of said correction means includes means for compensating linear and non-linear distortion caused by said associated amplifier.

3. An amplifier circuit as claimed in claims 1 or 2, wherein said intermediate amplifier stage includes an amplifier which subjects an inputted signal to shifts away from its intended values, said amplifier means including correction means associated with said amplifier of said intermediate amplifier stage for pre-distorting the signal input to said associated amplifier of said intermediate amplifier stage to compensate for the distortion caused by said associated amplifier of said intermediate amplifier stage.

4. An amplifier circuit as claimed in claim 3, wherein each of said correction means is controlled by an external input from an operator, and in which each of said correction means includes gain expansion/compression means for correcting AM to AM distortion caused by said associated amplifier, and phase expansion/compression means for correcting AM to PM distortion caused by said associated amplifier.

5. An amplifier circuit as claimed in claim 4, wherein each said correction means is adjustable, said correction means includes correction gain control means for maintaining signal amplitude constant as said correction means is adjusted, and said correction gain control means indudes means for coupling-off a sample of an output of said correction control means, means, for comparing the two samples, and means for attenuating signal amplitude.

6. An amplifier circuit as daimed in any of claims 1 to 5, wherein said correction means including automatic power control for maintaining the output level of said associated amplifier at a constant output level, and each os said correction means indudes gain modifying means for modifying gain and phase modifying means for modifying phase.

7. An amplifier circuit as claimed in claim 6, wherein said gain modifying means indudes means for splitting and inputted signal into two components, fixed attenuator means for operating upon a first one of said components, voltage dependent attenuator means for operating upon the second one of the said components, and means for combining the two operated-upon components, and said phase modifying means includes means for splitting an inputted signal into two components which are 90 degrees out of phase, fixed attenuator means for operating upon a first one of said components, voltage dependent attenuator means for operating upon the second one of said components, and means for combining the two operated-upon components.

8. An amplifier circuit for amplifying a signal, said amplifier circuit comprising a plurality of an amplifier stages in series along an amplifier path, each of said amplifier stages having an amplifier which subjects an inputted signal to distortion shifts away from their intended values, a plurality pre-corrector means, each of said pre-corrector means being associated with, and in series with, one of said amplifier stages and for pre-distorting the signal input to said associated amplifier stage to compensate for the distortion shifts of the associated amplifier, in which at least one of said pre-corrector means indudes for compensating for phase and amplitude distortion caused by said associated amplifier stage.

9. An amplifier circuit as claimed in claim 8, wherein at least one of said pre-corrector means includes means for compensating for linear and non-linear distortion caused by said associated amplifier stage, with at least one of said pre-corrector means being adjustable, said pre-corrector means including correction gain control means for maintaining signal amplitude constant as said pre-corrector means is adjusted, and said correction gain control means includes means for coupling-off a sample of signal input to said pre-corrector means, means for coupling-off a sample of an output of said correction gain control means, means for comparing the two samples, and means for attenuating signal amplitude in response to said comparison, in which said pre-corrector means induding automatic power control for maintaining the output level of said associated amplifier at a constant output level, and each os said pre-corrector means indudes gain modifying means for modifying gain and phase modifying means for modifying phase.

10. An amplifier circuit as claimed in claim 9, wherein said gain modifying means indudes means for splitting an inputted signal into two components, fixed attenuator means for operating upon a first one of said components, voltage dependent attenuator means for operating upon the second one of said components, and means for combining the two operated-upon components, and said phase modifying means includes means for splitting an inputted signal into two components which are 90 degrees out of phase, fixed attenuator means for operating upon a first one of side components, voltage dependant attenuator means for operating upon the second of said components, and means for combining the two operated-upon components.

11. A method for providing a amplified, corrected signal from and amplifier circuit, the amplifier circuit having an amplifier path and including a signal source, and intermediate amplifier stage, and a power amplifier stage connected sequentially, in series along said amplifier path, the power amplifier stage includes a plurality of amplifiers operationally connected in parallel, each of said amplifiers subjecting and inputted signal to shifts away from their intended values, said method comprising providing a plurality of correction means, connecting each of the correction means to be associated with one of said plurality of amplifiers and to be connected between an output of said intermediate amplifier stage and said associated amplifier, and pre-distorting the signal from the intermediate amplifier and input to the associated amplifier at each of the correction means to compensate for the distortion caused by said associated amplifier.
